# EUROPÄISCHE PATENTANMELDUNG

(11) **EP 4 576 795 A1**
(43) Veröffentlichungstag der Anmeldung: **25.06.2025**
(21) Anmeldenummer: 24216956.3
(22) Anmeldetag: 02.12.2024
(51) Int. Cl.: H04N 23/52, H05K 1/02

(54) **FAHRZEUGKAMERA MIT FLÄCHENHEIZUNG**

(30) Priorität: 22.12.2023 DE 102023136644
(71) Anmelder: MEKRA Lang GmbH & Co. KG, 91465 Ergersheim (DE)
(72) Erfinder: Schöfer, Bernhard, 91315 Höchstadt a d Aisch (DE)
(74) Vertreter: Alpspitz IP

(57) **Zusammenfassung**

Eine Kamera (20) für ein Fahrzeug, insbesondere ein Nutzfahrzeug, weist ein Gehäuse (22), zumindest ein in dem oder an dem Gehäuse (22) angeordnetes optisches Element (24), und eine Platine (10) mit wenigstens einem Bildsensor (16) und einer Flächenheizung (17) zur Beheizung des optischen Elements (24) auf.

## Beschreibung

### Gebiet der Erfindung

Die vorliegende Erfindung betrifft eine Kamera mit einer Flächenheizung, insbesondere eine Kamera für ein Fahrzeug, z. B. ein Nutzfahrzeug.

### Stand der Technik

Seit geraumer Zeit werden bei Fahrzeugen, insbesondere Nutzfahrzeugen, neben herkömmlichen Spiegeln als Einrichtungen zur indirekten Sicht, entweder in Ergänzung oder als Ersatz für diese Spiegel Kamerasysteme bzw. Bildaufnahmesysteme als Einrichtungen zur indirekten Sicht verwendet. Die Kamerasysteme weisen üblicherweise eine Bildaufnahmeeinheit, wie beispielsweise eine Kamera, auf, die die Fahrzeugumgebung kontinuierlich als (Video-)Daten erfasst. Die von der Bildaufnahmeeinheit erfassten (Video-)Daten werden, gegebenenfalls nach Bearbeitung, an eine sich im Fahrerhaus befindliche Wiedergabeeinheit übertragen, welche die (Video-)Daten dem Fahrer dauerhaft und in Echtzeit anzeigt und gegebenenfalls ergänzende Information, wie z. B. Kollisionshinweise, Abstände und Ähnliches, für den erfassten Umgebungsbereich einblendet.

Die Kameras von Kamerasystemen werden üblicherweise an einer Fahrzeugaußenseite angebracht. Entsprechend sind die Kameras jeglichen Witterungseinflüssen am Standort des Fahrzeugs ausgesetzt. Insbesondere bei niedrigen Temperaturen kann durch Frostschicht- oder Kondenswasserbildung auf dem optischen Element bzw. dem Deckglas des optischen Elements die Bilderfassungsfunktion der Kamera beeinträchtigt sein. Zudem besteht die Gefahr, dass Bauteile, die wiederholt niedrigen Temperaturen ausgesetzt sind, eine Materialveränderung erfahren und dadurch rascher verschleißen.

Um Frostschicht- bzw. Kondenswasserbildung auf dem optischen Element einer Kamera zu vermeiden, ist es bekannt, die Kamera zu beheizen. Dazu werden bislang Heizelemente, z.B. in Form von diskreten Widerständen, an bestimmten Positionen auf der Platine angeordnet, wie in der DE 10 2013 020 894 B3 offenbart ist. Jedoch beanspruchen diese Heizelemente verhältnismäßig viel Bauraum in der Kamera. Dadurch fehlt entweder Bauraum in der Kamera für andere Bauteile oder, wenn die anderen Bauteile dennoch verbaut werden, wird die Kamera insgesamt größer, was wiederum nachteilige Auswirkungen auf den benötigten Bauraum im Fahrzeug hat.

### Aufgabe der Erfindung

Davon ausgehend ist es Aufgabe der Erfindung, eine Kamera bereitzustellen, die eine kompakte Heizung aufweist, die einer Frost- und Kondenswasserbildung einerseits zuverlässig entgegenwirkt und andererseits einen geringen Bauraum in der Kamera beansprucht.

### Darstellung der Erfindung

Diese Aufgabe wird mit einer Kamera mit den Merkmalen des Anspruchs 1 und einem Fahrzeug mit den Merkmalen des Anspruchs 18 gelöst. Bevorzugte Ausführungsformen sind in den abhängigen Ansprüchen angegeben.

Der Erfindung liegt der Gedanke zugrunde, eine Kamera für ein Fahrzeug, insbesondere ein Nutzfahrzeug, mit einer Flächenheizung zu versehen. Die Flächenheizung ist zumindest teilweise auf der Platine aufgebracht, die auch den Bildsensor trägt. Die Flächenheizung ist aus einem wärmeleiten Material gebildet und erstreckt sich über eine gewissen Fläche der Platine. Unter einer Fläche wird vorliegend eine geometrische Form verstanden, genauer ein nach Länge und Breite flach ausgedehnter Bereich. Insbesondere definiert sich die Flächenheizung dadurch, dass ihre Länge- bzw. Breiteerstreckung ein Vielfaches größer ist als ihre Erstreckung in einer Dickenrichtung. Dabei sind die Längen- und Breitenrichtung der Flächenheizung so festgelegt, dass sie eine Ebene aufspannen, die im auf der Platine angeordneten Zustand im Wesentlichen parallel zu der Ebene ist, die von der Längen- und Breitenrichtung der Platine aufgespannt wird.

Durch eine Flächenheizung wird die Wärme über eine größere Fläche gleichmäßig in das optische Element der Kamera eingeleitet, da die Wärmeabstrahlfläche größer ist als bei herkömmlichen Heizelementen. Gleichzeitig wird durch die nur sehr geringe Erstreckung der Flächenheizung in der Dickenrichtung der Flächenheizung nur sehr wenig Bauraum in einer Längsrichtung der Kamera benötigt. Die Längsrichtung der Kamera definiert sich als die Richtung, in der ein Stecker, eine oder mehrere Platine(n) und ein optisches Element der Kamera hintereinander angeordnet sind.

Beispielsweise kann die Flächenheizung aus einem dünnen Metallbogen gebildet sein, der auf die Platine geklebt wird. Alternativ kann die Flächenheizung auch eine dünne Metallschicht sein, die auf die Platine gespritzt, gegossen, aufgedampft oder galvanisiert wird. Vorzugsweise ist die Flächenheizung jedoch aus einer Leiterbahn gebildet. Die Leiterbahn kann aus Kupfermaterial, Aluminium oder einer Kupferlegierung bzw. Aluminiumlegierung hergestellt sein. Alternativ kann die Leiterbahn auch aus einem anderen wärmeleitenden Material hergestellt sein. Um eine Flächenheizung vorzusehen, ist die Leiterbahn derart gelegt, dass einzelne Abschnitte der Leiterbahn oder bei mehreren Leiterbahnen die einzelnen Leiterbahnen nebeneinander, aneinander angrenzend auf der Platine angeordnet sind. Aneinander angrenzend bedeutet vorliegend, dass kein weiteres Element zwischen den einzelnen Abschnitten der Leiterbahne(n) vorhanden ist, die Abschnitte sich jedoch nicht berühren. Beispielsweise kann die Leiterbahn mäanderförmig gelegt sein. Mäanderförmig bedeutet vorliegend, dass die Leiterbahn in Schleifen bzw. Windungen derart gelegt ist, dass sie an zwei vordefinierten Endpositionen jeweils die Richtung um in etwa 180 Grad ändert. So weist die Leiterbahn mehrere Leiterbahnabschnitte auf, die ohne Unterbrechung annähernd parallel zueinander verlaufen. Eine mäanderförmige Anordnung hat den Vorteil, dass - im Gegensatz zu einer spiralförmigen Anordnung der Leiterbahn - eine Antennenwirkung der Leiterbahn vermieden wird und dadurch weder die Elektronik der Kamera noch benachbarte Geräte durch ausgesendete Störstrahlung gestört werden und so die elektromagnetische Verträglichkeit gewährleistet wird.

Die Heizleistung der durch eine Leiterbahn ausgebildeten Flächenheizung ergibt sich aus dem Querschnitt und der Länge der Leiterbahn sowie deren Anordnung, nachfolgend bezeichnet als die Geometrie der Flächenheizung. Über die spezifische Wärmeleitfähigkeit des für die Leiterbahn verwendeten Materials sowie die Länge und den Querschnitt der Leiterbahn kann ein Widerstand generiert werden. Somit kann für eine vorgegebene Stromstärke oder eine vorgegebene Spannung sowie eine vorgegebene Heizleistung ein Widerstand errechnet werden, der dann wiederum in eine geeignete Leiterbahngeometrie überführt werden kann.

Zur effektiven Erwärmung des optischen Elements, ist es bevorzugt, dass sich die Leiterbahn teilweise um den Bildsensor herum erstreckt. Alternativ kann die Leiterbahn den Bildsensor auch ganz umgeben.

Da die Erwärmung der Kamera vorrangig der Vermeidung von Frostschicht- und Kondenswasserbildung dient, ist es vorteilhaft, wenn die Leiterbahn auf der Seite der Platine angeordnet ist, auf der auch der Bildsensor angeordnet ist und die entsprechend auf das optische Element gerichtet ist. Alternativ kann die Leiterbahn aber auch auf der von dem optischen Element abgewandten Seite angeordnet sein oder es kann auf beiden Seiten der Platine eine Leiterbahn angeordnet sein.

Nach einer bevorzugten Ausführungsform entspricht die Außenbegrenzung der flächig angeordneten Leiterbahn auf der Platine im Wesentlichen der Außenabmessung des optischen Elements. So kann ein effizienter Wärmeeintrag in das optische Element sichergestellt werden.

Vorzugsweise ist die Leiterbahn auf einer bestimmten Leiterplattenschicht angeordnet, weiter vorzugsweise auf der Leiterplattenschicht, auf der auch der Bildsensor angeordnet ist. Alternativ kann die Leiterbahn auch auf einer anderen, beispielsweise innenliegenden oder auf einer Leiterplattenschicht auf der Seite der Platine, die der Seite mit dem Bildsensor gegenüberliegt, angeordnet sein. Dadurch dass die Leiterbahn auf nur einer Leiterplattenschicht angeordnet ist, weist die Leiterbahn weiter vorzugsweise eine im Wesentlichen zweidimensionale ebene Form auf, bei der die Leiterbahn zwar eine Erstreckung in eine Längen- und Breitenrichtung aufweist, jedoch kaum eine Erstreckung in einer Dickenrichtung.

Weiter alternativ kann sich die Leiterbahn über mehrere im Wesentlichen parallele Leiterplattenschichten erstrecken. Das bedeutet, dass die Leiterbahn derart angeordnet ist, dass sie zwar in einer Draufsicht auf die Platine, eine flächige Anordnung durch aneinandergrenzende Leiterbahnabschnitte oder Leiterbahnen aufweist, in einer Schnittansicht der Platine aber zwischen verschiedenen parallelen Leiterplattenschichten wechselt. Mit anderen Worten sind in einem Schnitt durch die Platine auf mehreren Leiterplattenschichten Leiterbahnen vorhanden, die zwischen den Leiterplattenschichten wechseln. Unter dem Begriff "Flächenheizung" ist somit auch eine Anordnung zu verstehen, deren einzelne Abschnitte flach ausgebildet sind und damit nur eine sehr geringe Erstreckung in Dickenrichtung der Leiterbahn aufweisen, die jedoch insgesamt in einer Schnitt- oder Seitenansicht keine ebene Ausgestaltung, sondern eine in Bezug auf die Dickenrichtung der Platine verschiedene Höhenlagen einnehmende Ausgestaltung unter Beibehaltung einer sich in einer Dickenrichtung nur sehr gering erstreckenden Dimension aufweist.

Um eine Erwärmung des Bildsensors und damit ein Bildrauschen zu vermeiden, kann die Leiterplattenschicht, auf der der Bildsensor angeordnet ist, zwischen Bildsensor und Leiterbahn entfernt sein. Das heißt, es ist zwischen Bildsensor und Leiterbahn kein wärmeleitendes Material vorhanden. So kann vermieden werden, dass sich die Wärme der Leiterbahn auf den Bildsensor überträgt, was wiederum eine zuverlässige Funktion des Bildsensors fördert. Verstärkt kann diese Wirkung noch werden, indem der von wärmeleitendem Material freigelegte Raum mit einem wärmeisolierenden Material gefüllt wird. Alternativ oder zusätzlich zu einem Entfernen der Leiterplattenschicht kann auch eine Wärmebarriere zwischen Bildsensor und Leiterbahn vorgesehen sein. Die Wärmebarriere kann entweder aus einem wärmeisolierenden Material gebildet sein und zur Wärmeisolierung dienen oder kann aus einem wärmeleitenden Material, z.B. dem Material der Leiterbahn, gebildet sein und zur Wärmespeicherung bzw. als Wärmepuffer dienen. Um ausreichend Wärme aufnehmen bzw. puffern zu können, weist die Wärmebarriere eine gewisse thermische Kapazität auf. Der Begriff der thermischen Kapazität bedeutet vorliegend die Fähigkeit, Wärme aufzunehmen und zu speichern. Beispielsweise kann die Wärmebarriere als ein Ring mit einer gewissen Erstreckung in Längsrichtung der Kamera bzw. Dickenrichtung der Leiterbahn ausgebildet sein, so dass die Wärmebarriere eine bestimmte Materialansammlung zur Speicherung von Wärmeenergie aufweist.

Vorzugsweise enthält die Kamera wenigstens eine zweite Leiterbahn zur gezielten Ansteuerung je nach Heizleistungsbedarf. Beispielsweise kann die Kamera zwei Leiterbahnen aufweisen, die beide wie oben beschrieben ausgebildet sein können und entweder konzentrisch zueinander oder um den Bildsensor herum nebeneinander angeordnet sein können. Während des Betriebs der Heizung kann eine der beiden Leiterbahnen nur zu der anderen Leiterbahn hinzugeschaltet werden, wenn eine höhere Heizleistung erforderlich ist, wie dies beispielsweise bei Temperaturen unter dem Gefrierpunkt der Fall ist. Alternativ oder zusätzlich zur Anpassung der Heizleistung kann sich der Querschnitt der Leiterbahn über die Erstreckung der Leiterbahn ändern. Beispielsweise kann die Leiterbahn einen kontinuierlich variierenden Querschnitt aufweisen oder aber auch nur abschnittsweise in Bezug auf den Querschnitt variieren.

Zur Befestigung des optischen Elements in oder an dem Gehäuse der Kamera, kann ein Wärmeleitelementzwischen dem optischen Element und dem Gehäuse vorgesehen sein. Vorzugsweise ist das Wärmeleitelement durch eine Vergussmasse gebildet, die das optische Element in dem Gehäuse fixiert und aus einem wärmeleitenden Material hergestellt ist. So kann die Wärme der Leiterbahn nicht nur unmittelbar in das optische Element, sondern auch über die Vergussmasse indirekt in das optische Element eingeleitet werden, indem die Wärme zunächst in das Gehäuse der Kamera und über das Gehäuse der Kamera in das optische Element eingeleitet wird. Auf diese Weise wird eine noch effizientere und raschere Erwärmung des optischen Elements gefördert.

Alternativ oder zusätzlich kann das optische Element über einen Kleber an der Platine befestigt sein. Der Kleber ist vorzugsweise ebenfalls aus einem wärmeleitenden Material, so dass ein zuverlässiger Wärmeeintrag von der Leiterbahn in das optische Element erfolgt.

Vorzugsweise enthält die Kamera wenigstens einen Temperatursensor zur Anpassung der Heizleistung und/oder zur Anpassung der Heizdauer. Der Temperatursensor dient dazu, Temperaturzustände im Inneren des Kameragehäuses und/oder am optischen Element zu ermitteln, welche entweder eine Anpassung der Heizleistung und/oder eine Anpassung der Heizdauer erfordern. Dazu ist der Sensor vorzugsweise im Inneren des Kameragehäuses, z.B. eingebettet in die Vergussmasse und/oder den Kleber, vorzugsweise an dem oder in der Nähe des optischen Elements angeordnet. Ermittelt der Temperatursensor z.B., dass die Temperatur im Inneren des Kameragehäuses einen bestimmten, vorgegebenen Wert überschritten hat, so kann dieses Ergebnis über eine zentrale Steuereinheit (ECU) an eine Regelungseinheit weitergeleitet werden, die daraufhin die Heizleistung reduziert oder ganz abschaltet. Andersherum kann die Regelungseinheit die Heizleistung auch starten oder erhöhen, wenn der Temperatursensor ermittelt, dass die Temperatur im Inneren des Kameragehäuses unterhalb einen vorgegebenen Temperaturschwellenwert gefallen ist. Die Überwachung der Temperatur im Inneren des Kameragehäuses kann zusätzlich oder alternativ auch durch einen Bediener, z.B. den Fahrer des Fahrzeugs, initiiert werden. Dazu ist eine Bedienerschaltfläche/einen Bedienerknopf, wie z.B. ein Bediener-Interface mit einem Ein-/Aus-Schalter, im Inneren des Fahrzeugs vorgesehen, mittels dem der Bediener den Betrieb der Flächenheizung starten oder beenden kann. Alternativ oder zusätzlich kann eine Steuerung der Temperatur im Inneren des Kameragehäuses auch über die Festlegung einer Heizdauer erfolgen.

Grundsätzlich kann der Betrieb der Flächenheizung über die ECU in Verbindung mit einer Regelungseinheit erfolgen, indem Temperatursensoren Temperaturwerte ermitteln und melden und bei Unter- oder Überschreitung vorgegebener Temperaturwerte die Flächenheizung betrieben oder nicht länger betrieben wird. Alternativ oder zusätzlich kann die Flächenheizung auch von einem Bediener gestartet werden, , z.B. über bestimmte dafür in einem Fahrgastraum des Fahrzeugs vorgesehene Bedienmittel, wenn dieser bei niedrigen Temperaturen und dadurch entweder Kondenswasser- oder Frostschichtbildung keine ausreichend guten Kamerabilder erhält.

Zusätzlich oder alternativ zu dem wenigstens einen Temperatursensor kann wenigstens ein Stromsensor vorgesehen sein, der die Stromstärke in der Leiterbahn ermittelt und die Heizleistung bzw. Heizdauer über eine Regelungseinheit gegebenenfalls anpasst, wenn eine in der Leiterbahn vorliegenden Stromstärke einen zulässigen Wert überschreitet oder einen erforderlichen Wert unterschreitet. Der Stromsensor kann in der Wärmebarriere oder auf der Platine vorgesehen sein. Auch hier kann eine manuelle Einstellung der Heizleistung bzw.- Heizdauer in Abhängigkeit von der vorliegenden Stromstärke durch einen Bediener erfolgen. Dazu wird der Bediener über die vorliegende Stromstärke informiert und kann diese entsprechend anpassen, wobei die Bedienereingabe bei für die Heizung schädlichen Anpassungen durch den Bediener von der Steuereinheit übersteuert werden kann, um eine etwaige Beschädigung der Flächenheizung und der Kamera zu vermeiden.

Die wenigstens eine Leiterbahn wird vorzugsweise nicht nur dazu verwendet, das optische Element zu erwärmen, sondern wird auch als Stromversorgungsleitung für sich auf der Platine befindliche Bauteile, wie z.B. den Bildsensor, verwendet. Durch die gleichzeitige Verwendung der Leiterbahn als Zuleitung ergibt sich ein Spannungsabfall, der bei der Auslegung der Leiterbahn berücksichtigt werden muss.

### Kurze Beschreibung der Figuren

Nachfolgend wird die Erfindung beispielhaft anhand der beigefügten Figuren beschrieben, in denen:
- Fig. 1: einen Längsschnitt durch eine erfindungsgemäße Kamera mit einer Flächenheizung gemäß einer ersten Ausführungsform zeigt,
- Fig. 2: eine perspektivische Ansicht einer Platine mit Leiterbahn und optischem Element zeigt,
- Fig. 3: eine Draufsicht auf eine Platine mit Leiterbahn, Bildsensor und Wärmebarriere zeigt, und
- Fig. 4: eine perspektivische Ansicht einer Platine mit einer Flächenheizung gemäß einer zweiten Ausführungsform zeigt.

### Aspekte der Erfindung

Die Erfindung umfasst folgende Aspekte:
1. Kamera (20) für ein Fahrzeug, insbesondere ein Nutzfahrzeug, enthaltend:
   ein Gehäuse (22),
   zumindest ein in dem oder an dem Gehäuse (22) angeordnetes optisches Element (24), und
   eine Platine (10) mit wenigstens einem Bildsensor (16) und einer Flächenheizung (17) zur Beheizung des optischen Elements (24).
2. Kamera (20) nach Aspekt 1, wobei die Flächenheizung (17) aus wenigstens einer Leiter-bahn (18) gebildet ist, wobei Leiterbahnabschnitte der Leiterbahn (18) zum Bilden einer flächigen Anordnung auf der Platine (10) aneinander angrenzend angeordnet sind.
3. Kamera (20) nach Aspekt 2, wobei die Leiterbahn (18) mäanderförmig angeordnet ist.
4. Kamera (20) nach Aspekt 2 oder 3, wobei die Leiterbahn (18) wenigstens teilweise um den Bildsensor (16) herum angeordnet ist.
5. Kamera (20) nach einem der Aspekte 2 bis 4, wobei die Leiterbahn (18) auf der Seite der Platine (10) angeordnet ist, die auf das optische Element (24) gerichtet ist.
6. Kamera (20) nach einem der Aspekte 2 bis 5, wobei die Außenbegrenzung der Leiterbahn (18) auf der Platine im Wesentlichen der Außenabmessung der auf die Leiterbahn (18) ge-richteten Fläche des optischen Elements (24) entspricht.
7. Kamera (20) nach einem der Aspekte 2 bis 6, wobei die Leiterbahn (18) auf einer bestimmten Leiterplattenschicht (12) der Platine (10) angeordnet ist.
8. Kamera (20) nach Aspekt 7, wobei die Leiterbahn (18) eine im Wesentlichen zweidimensional Form aufweist.
9. Kamera (20) nach einem der Aspekte 2 bis 6, wobei sich die Leiterbahn (18) über mehrere im Wesentlichen zueinander parallele Leiterplattenschichten (12) erstreckt.
10. Kamera (20) nach Aspekt 9, wobei die Leiterbahn (18) vorzugsweise eine dreidimensionale Form aufweist.
11. Kamera (20) nach einem der Aspekte 5 bis 10, wobei die Leiterplattenschicht (12) in einem Bereich zwischen Bildsensor (16) und Leiterbahn (18) freigehalten ist.
12. Kamera (20) nach einem der Aspekte 2 bis 11, wobei eine Wärmebarriere (13) zwischen Bildsensor (16) und Leiterbahn (18) vorgesehen ist.
13. Kamera (20) nach Aspekt 12, wobei die Wärmebarriere (13) aus einem wärmeleitenden Material gebildet ist und derart ausgebildet ist, dass sie eine thermische Kapazität aufweist.
14. Kamera (20) nach einem der Aspekte 2 bis 13, enthaltend wenigstens eine zweite Leiterbahn (18) zur gezielten Ansteuerung je nach Heizleistungsbedarf.
15. Kamera (20) nach einem der Aspekte 1 bis 14, ferner enthaltend eine wärmeleitende Vergussmasse (28), die zwischen der Platine (10), dem Gehäuse (22) und dem optischen Element (24) angeordnet ist.
16. Kamera (20) nach einem der Aspekte 1 bis 15, ferner enthaltend wenigstens einen Temperatursensor zur Ermittlung einer Temperatur im Inneren des Gehäuses (22) zur Anpassung der Heizleistung und/oder zur Anpassung der Heizdauer.
17. Kamera (20) nach einem der Aspekte 2 bis 16, wobei die wenigstens eine Leiterbahn (18) angepasst ist zur Verwendung als Stromversorgungsleitung für den Bildsensor (16) und/oder weitere Bauteile (14) auf der Platine (10).
18. Fahrzeug mit einer Kamera (20) nach einem der Aspekte 1 bis 17.

### Beschreibung bevorzugter Ausführungsformen

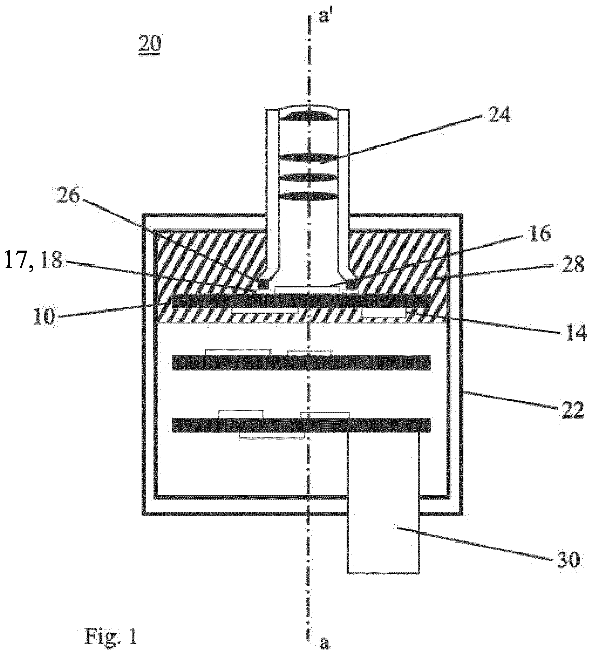

Fig. 1 zeigt einen Längsschnitt durch eine Kamera 20 für ein Fahrzeug, die eine Mittelachse a-a' aufweist. Die Kamera 20 weist ein Gehäuse 22 auf. Im Inneren des Gehäuses 22 sind ein optisches Element 24 und mehrere Platinen 10 angeordnet. Das optische Element 24 besteht aus einem Objektiv und einem Deckglas zum Schutz des Objektivs. Auf der dem optischen Element 24 am nächstliegenden Platine 10 ist auf der dem optischen Element 24 zugewandten Seite mittig ein Bildsensor 16 zur Aufnahme von Bildern einer Umgebung um das Fahrzeug herum angeordnet. Auf der gegenüberliegenden Seite, d.h. der von dem optischen Element 24 abgewandten Seite der Platine 10, sind elektronische Bauteile 14 angeordnet, die zum Ausführen einer Kamerafunktion erforderlich sind. Die elektronischen Bauteile 14 können alternativ oder zusätzlich auch auf der dem optischen Element zugewandten Seite auf der Platine 10 angeordnet sein. Die von dem optischen Element 24 am weitesten entfernt liegende Platine ist mit einem Stecker 30 zur Spannungsversorgung der Kamera und zur Datenübertragung versehen. Die Platinen sind leitend miteinander verbunden (nicht gezeigt). Die Richtung entlang der Längsachse a-a', in der die Platinen, der Bildsensor 16 und das optische Element 24 hintereinander angeordnet sind, wird vorliegend als Längsrichtung bezeichnet.

Um den Bildsensor 16 herum, d.h. auf der dem optischen Element 24 zugewandten Seite der Platine 10 ist eine als Leiterbahn 18 ausgebildete Flächenheizung 17 angeordnet. Die Außenmaße der Leiterbahn 18 entsprechen im Wesentlichen den Außenmaßen der auf die Platine 10 gerichteten Fläche des optischen Elements 24.

Das optische Element 24 ist über eine Vergussmasse 28 mit dem Gehäuse 22 und der Platine 10 verbunden. Die Vergussmasse 28 ist aus einem wärmeleitenden Material gebildet, wie beispielsweise auf Polyurethanbasis.

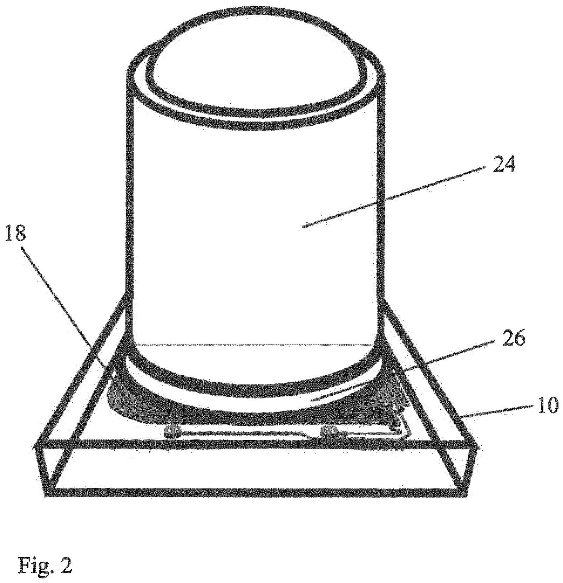

Fig. 2 zeigt eine perspektivische Ansicht der Platine 10 mit dem optischen Element 24. Wie in Fig. 2 gezeigt ist, ist eine auf die Platine 10 gerichtete Stirnfläche des optischen Elements 24 mittels eines Klebers 26 mit der Platine 10, genauer mit der Leiterbahn 18 verbunden, wie beispielsweise ein Sekundenkleber, ein Zwei-Komponenten-Kleber, und ähnliches. Wie auch die Vergussmasse 28 ist auch der Kleber 26 aus einem wärmeleitenden Material gebildet. Wie Fig. 2 ferner entnommen werden kann, ist die Leiterbahn 18 mäanderförmig um den Bildsensor 16 (in Fig. 2 nicht gezeigt) herum angeordnet, wobei die einzelnen Windungen bzw. Leiterbahnbereiche an einer bestimmten Position in Bezug auf den Bildsensor 16 ihre Laufrichtung um etwa 180 Grad ändern.

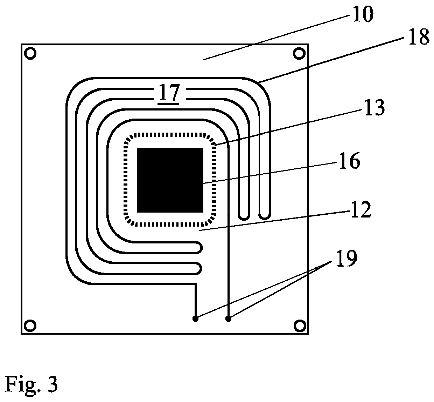

Fig. 3 zeigt eine Draufsicht auf die Platine 10 aus Fig. 1. Wie in Fig. 3 gezeigt, ist in etwa der Mitte der Platine der Bildsensor 16 angeordnet. Die Position des Bildsensors 16 auf der Platine 10 kann jedoch auch außermittig liegen und ist grundsätzlich so zu wählen, dass das optische Element 24 wenigstens teilweise Bilder der Fahrzeugumgebung auf dem Bildsensor 16 abbilden kann. Das heißt, es ist nicht erforderlich, aber dennoch möglich, dass das optische Element 24 exakt über dem Bildsensor 16 angeordnet ist. Um den Bildsensor 16 herum ist die Leiterbahn 18 angeordnet. Die Leiterbahn 18 ist mäanderförmig um den Bildsensor 16 herum gelegt, um eine Antennenwirkung der Leiterbahn 18 zu vermeiden. Die Anschlussenden 19 der Leiterbahn 18 sind ebenfalls auf der Platine 10 vorgesehen und sind leitend mit einer Stromquelle (nicht gezeigt) verbunden. Der Bildsensor 16 und die Leiterbahn 18 sind auf einer Leiterplattenschicht 12 aufgebracht. Die Leiterplattenschicht 12 ist aus einem wärmeleitenden Metall gebildet, z.B. aus Kupfer, und bildet eine Kupferlage.

Zwischen Bildsensor 16 und Leiterbahn 18 ist eine Wärmebarriere 13 vorgesehen. Die Wärmebarriere 13 ist als eine geschlossene Absperrung, z. B. als ein Ring ausgeführt und umgibt den Bildsensor 16 vollständig. Die Wärmebarriere 13 kann aus einem wärmeisolierenden Material gebildet sein oder kann aus einem Metall gebildet sein, beispielsweise aus demselben Material wie die Leiterplattenschicht 12. Alternativ oder zusätzlich zu der Wärmebarriere 13 kann die Leiterplattenschicht 12 zwischen Bildsensor 16 und Leiterbahn 18 auch weggelassen sein. So wird - gegebenenfalls zusätzlich zu der Wärmebarriere 13 - vermieden, dass sich die Wärme der Leiterbahn 18 über die Leiterplattenschicht 12 auf den Bildsensor 16 überträgt.

Zur Beheizung der Kamera 20 wird die Leiterbahn 18 mit Strom beaufschlagt, was dazu führt, dass sich die Leiterbahn 18 erwärmt. Durch die räumliche Nähe der Leiterbahn 18 zu dem optischen Element 24 wird die Wärme der Leiterbahn 18 durch thermische Konvektion über die Luft auf das optische Element 24 übertragen. Zusätzlich wird die Wärmeenergie der Leiterbahn 18 über den wärmeleitenden Kleber 26 unmittelbar, d.h. von der Leiterbahn 18 ohne ein weiteres Element als den Kleber 26, auf das optische Element 24 übertragen. Zusätzlich wird die Wärme der Leiterbahn 18 auch über die wärmeleitende Vergussmasse 28 auf das Gehäuse 22 und von dem Gehäuse 22 über thermische Konvektion über die Luft auf das optische Element 24 übertragen. So kann Kondenswasser- oder Frostschichtbildung auf dem optischen Element vermieden werden oder eine bereits bestehende Frostschicht oder Kondenswasser können entfernt werden.

Es ist denkbar, dass die Stromstärke oder die Spannung des durch den Leiter fließenden Stroms je nach gewünschter Heizleistung variiert. Zusätzlich oder alternativ ist es zur Variierung der Heizleistung denkbar, dass nicht nur eine Leiterbahn 18, sondern mehrere Leiterbahnen 18 auf der Platine 10 vorgesehen sind, die einzeln oder gemeinsam betrieben werden können. Ebenso ist es denkbar, dass die Leiterbahn 18 nicht über ihren gesamten Verlauf den gleichen Querschnitt aufweist, sondern, dass sich dieser über die Erstreckung der Leiterbahn 18 ändern kann. Beispielsweise kann die Leiterbahn 18 einen kontinuierlich variierenden Querschnitt aufweisen oder aber auch nur abschnittsweise in Bezug auf den Querschnitt variieren. Allgemein gilt, dass je kleiner der Querschnitt und je länger die Leiterbahn, sich der Widerstand erhöht und andersherum. So kann ausgehend von einer gewünschten Heizleistung und einer vorgegebenen Stromstärke oder Spannung sowie der spezifischen Wärmeleitfähigkeit des gewählten Materials für die Leiterbahn 18 ein Querschnitt und eine Länge der Leiterbahn 18 berechnet werden.

Die Wärmebarriere 13 wirkt als eine Art Schutzring zur Vermeidung, dass sich Wärme von der Leiterbahn 18 auf den Bildsensor 16 überträgt. Entweder verhindert die Wärmebarriere 13 eine Wärmeübertragung auf den Bildsensor 16, indem sie aus einem wärmeisolierenden Material gebildet ist und den Bildsensor 16 von der Leiterbahn 18 isoliert. Oder die Wärmebarriere 13 ist aus einem wärmeleitenden Material gebildet und speichert die Wärme der Leiterbahn 18, so dass sich diese nicht auf den Bildsensor 16 überträgt oder erst nach geraumer Zeit überträgt. Unterstützt wird der Effekt der Wärmeisolierung weiter dadurch, dass die Leiterplattenschicht 12 zwischen Bildsensor 16 und Leiterbahn 18 weggelassen bzw. freigehalten sein kann. Das Weglassen der Leiterplattenschicht 12 zwischen Bildsensor 16 und Leiterbahn 18 kann auch als einzige Maßnahme (d.h. ohne das Vorsehen einer Wärmebarriere 13) zur Wärmeisolierung des Bildsensors 16 vorgesehen sein.

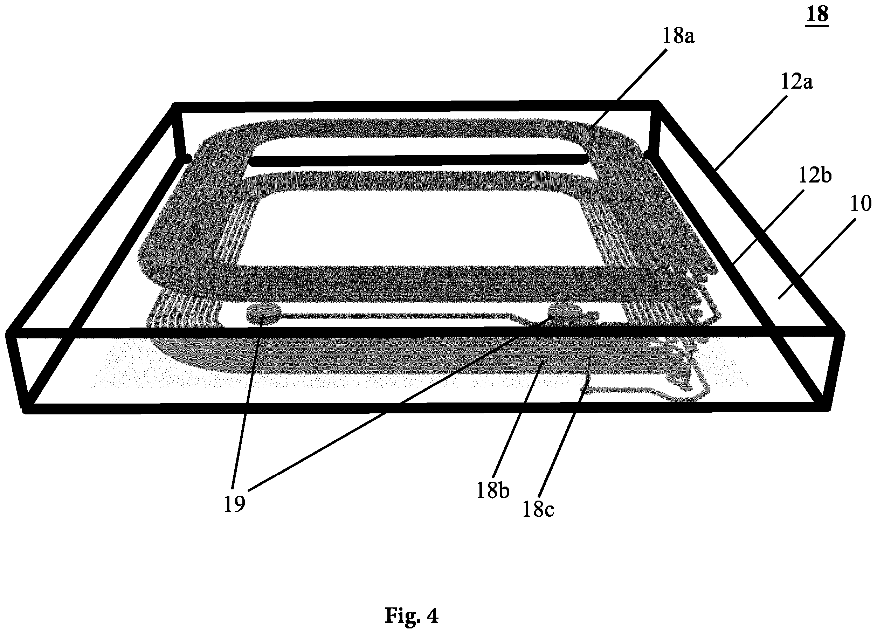

Fig. 4 zeigt eine perspektivische Ansicht einer Platine 10, bei der die Leiterbahn 18 nicht nur auf einer Leiterplattenschicht 12 angeordnet ist, sondern bei der sich die Leiterbahn 18 über mehrere Leiterplattenschichten erstreckt.

Bei der in Fig. 4 gezeigten Ausführungsform der als Leiterbahn 18 ausgebildeten Flächenheizung 17 ist diese im Wesentlichen aus zwei Leiterbahnbereichen 18a und 18b gebildet. Der erste Leiterbahnbereich 18a verläuft auf einer ersten Leiterplattenschicht 12a, wohingegen der zweite Leiterbahnbereich 18b auf einer zweiten zu der ersten Leiterplattenschicht (nicht gezeigt) im Wesentlichen parallelen Leiterplattenschicht 12b verläuft. Die beiden Leiterbahnbereiche 18a und 18b sind durch einen Leiterbahnsteg 18c miteinander leitend verbunden. Da der Leiterbahnsteg 18c eine Verbindung zwischen dem ersten Leiterbahnbereich 18a, der sich auf der ersten Leiterplattenschicht 12a befindet, und dem zweiten Leiterbahnbereich 18b, der sich auf der weiteren Leiterplattenschicht 12b befindet, herstellt, erstreckt er sich in eine weitere Raumrichtung und die Leiterbahn 18 ist an der Position des Leiterbahnstegs 18c dreidimensional ausgebildet. Grundsätzlich ist die Leiterbahn 18 durch die Leiterbahnbereiche 18a und 18b jedoch überwiegend und damit über große Abschnitte zweidimensional ausgebildet.

Auch wenn Fig. 4 eine im Wesentlichen exakte Überdeckung bzw. gleiche Ausbildung der beiden Leiterbahnbereiche 18a und 18b zeigt, ist es möglich, dass die Leiterbahnbereiche 18a und 18b zwar in Bezug auf ihre flächige Erstreckung gleich ausgebildet sind, aber in Querrichtung zur Längsrichtung der Kamera versetzt angeordnet sind. Alternativ oder zusätzlich ist es auch denkbar, dass die Leiterbahnbereiche 18a, 18b in Bezug auf ihre flächige Erstreckung unterschiedlich ausgebildet sind. Zum Beispiel ist es denkbar, dass der sich näher an dem optischen Element 24 befindliche Leiterbahnbereich 18a flächenmäßig eine größere Erstreckung aufweist als der Leiterbahnbereich 18b, der im Vergleich zu dem Leiterbahnbereich 18a weiter entfernt von dem optischen Element 24 angeordnet ist. Auch können sich Querschnitt und Material der Leiterbahnbereiche 18a, 18b unterscheiden. Ein geeigneter Wechsel des Querschnitts und/oder des Materials wäre hierfür an dem Leiterbahnsteg 18c, kann aber auch an jeder anderen Stelle der Leiterbahnbereiche 18a und 18b erfolgen.

### Bezugszeichenliste

- 10: Platine
- 12, 12a, 12b: Leiterplattenschicht
- 13: Wärmebarriere
- 14: elektronisches Bauteil
- 16: Bildsensor
- 17: Flächenheizung
- 18: Leiterbahn
- 18a, 18b: Leiterbahnbereiche
- 19: Stromanschlüsse
- 20: Kamera
- 22: Gehäuse
- 24: optisches Element
- 26: Kleber
- 28: Vergussmasse
- 30: Stecker
- a-a': Mittelachse

## Patentansprüche

1. Kamera (20) für ein Fahrzeug, insbesondere ein Nutzfahrzeug, enthaltend:
ein Gehäuse (22),
zumindest ein in dem oder an dem Gehäuse (22) angeordnetes optisches Element (24), und
eine Platine (10) mit wenigstens einem Bildsensor (16) und einer Flächenheizung (17) zur Beheizung des optischen Elements (24).

2. Kamera (20) nach Anspruch 1, wobei die Flächenheizung (17) aus wenigstens einer Leiterbahn (18) gebildet ist, wobei Leiterbahnabschnitte der Leiterbahn (18) zum Bilden einer flächigen Anordnung auf der Platine (10) aneinander angrenzend angeordnet sind.

3. Kamera (20) nach Anspruch 2, wobei die Leiterbahn (18) mäanderförmig angeordnet ist.

4. Kamera (20) nach Anspruch 2 oder 3, wobei die Leiterbahn (18) wenigstens teilweise um den Bildsensor (16) herum angeordnet ist.

5. Kamera (20) nach einem der Ansprüche 2 bis 4, wobei die Leiterbahn (18) auf der Seite der Platine (10) angeordnet ist, die auf das optische Element (24) gerichtet ist.

6. Kamera (20) nach einem der Ansprüche 2 bis 5, wobei die Außenbegrenzung der Leiterbahn (18) auf der Platine im Wesentlichen der Außenabmessung der auf die Leiterbahn (18) gerichteten Fläche des optischen Elements (24) entspricht.

7. Kamera (20) nach einem der Ansprüche 2 bis 6, wobei die Leiterbahn (18) auf einer bestimmten Leiterplattenschicht (12) der Platine (10) angeordnet ist, wobei die Leiterbahn (18) vorzugsweise eine im Wesentlichen zweidimensional Form aufweist.

8. Kamera (20) nach einem der Ansprüche 2 bis 6, wobei sich die Leiterbahn (18) über mehrere im Wesentlichen zueinander parallele Leiterplattenschichten (12) erstreckt, wobei die Leiterbahn (18) vorzugsweise eine dreidimensionale Form aufweist.

9. Kamera (20) nach einem der Ansprüche 5 bis 8, wobei die Leiterplattenschicht (12) in einem Bereich zwischen Bildsensor (16) und Leiterbahn (18) freigehalten ist.

10. Kamera (20) nach einem der Ansprüche 2 bis 9, wobei eine Wärmebarriere (13) zwischen Bildsensor (16) und Leiterbahn (18) vorgesehen ist, wobei die Wärmebarriere (13) vorzugsweise aus einem wärmeleitenden Material gebildet ist und derart ausgebildet ist, dass sie eine thermische Kapazität aufweist.

11. Kamera (20) nach einem der Ansprüche 2 bis 10, enthaltend wenigstens eine zweite Leiterbahn (18) zur gezielten Ansteuerung je nach Heizleistungsbedarf.

12. Kamera (20) nach einem der Ansprüche 1 bis 11, ferner enthaltend eine wärmeleitende Vergussmasse (28), die zwischen der Platine (10), dem Gehäuse (22) und dem optischen Element (24) angeordnet ist.

13. Kamera (20) nach einem der Ansprüche 1 bis 12, ferner enthaltend wenigstens einen Temperatursensor zur Ermittlung einer Temperatur im Inneren des Gehäuses (22) zur Anpassung der Heizleistung und/oder zur Anpassung der Heizdauer.

14. Kamera (20) nach einem der Ansprüche 2 bis 13, wobei die wenigstens eine Leiterbahn (18) angepasst ist zur Verwendung als Stromversorgungsleitung für den Bildsensor (16) und/oder weitere Bauteile (14) auf der Platine (10).

15. Fahrzeug mit einer Kamera (20) nach einem der Ansprüche 1 bis 14.
